# EUROPEAN PATENT APPLICATION

(11) **EP 4 769 591 A1**
(43) Date of publication of application: **01.07.2026**
(21) Application number: 25186170.4
(22) Date of filing: 30.06.2025
(51) Int. Cl.: H01M 10/04, B07C 5/02, B07C 5/36, G01R 31/01, G01R 31/385, H01M 10/42, B07C 5/344

(54) **BATTERY CELL DETECTION SYSTEM AND METHOD OF DETECTING THE SAME**

(30) Priority: 27.12.2024 CN 202411958751
(71) Applicant: NUCTECH COMPANY LIMITED, Beijing 100084 (CN); Tsinghua University, Haidian District, Beijing 100084 (CN)
(72) Inventor: ZHANG, Li, Beijing, 100084 (CN); LI, Liang, Beijing, 100084 (CN); HONG, Mingzhi, Beijing, 100084 (CN); WANG, Zinan, Beijing, 100084 (CN); YE, Shuai, Beijing, 100084 (CN); CHANG, Ming, Beijing, 100084 (CN)
(74) Representative: Isarpatent

(57) **Abstract**

A battery cell detection system and a method of detecting the same is provided by the embodiments of the present disclosure. The battery cell detection system includes: a loading device (10), a first detection device (20), a second detection device (30), a sorting device (40) and an unloading device (50) arranged in sequence in a conveying direction. The loading device (10) is configured to transport a tray carrying a battery cell (600) to the first detection device (20). The first detection device (20) is configured to detect the battery cell (600) and generate a first detection sub-result. The second detection device (30) is configured to detect the battery cell (600) and generate a second detection sub-result. The sorting device (40) is configured to sort an abnormal battery cell (600) to a first target region. The unloading device (50) is configured to transport a normal battery cell (600) to a second target region. In the battery cell detection system, an automatic operation of a whole detection task of loading, detection, sorting and unloading may be realized through a collaborative cooperation of various devices, which may effectively improve a detection efficiency and a detection accuracy of the battery cell detection system.

## Description

### TECHNICAL FIELD

The present disclosure relates to the field of detection apparatus technologies, and in particular, to a battery cell detection system and a method of detecting the same.

### BACKGROUND

A battery cell is an important component inside a battery, a quality of the battery cell determines a quality of the battery to a great extent, and the quality of the battery cell needs to be detected before assembling the battery cell.

In the related art, a plurality of links of a battery cell detection system require manual participation. For example, links such as picking and placing of a battery cell, sorting of an unqualified battery cell, etc., need a manual operation. Due to an uncontrollability of the manual operation, a placement position, a feeding angle, etc., of the battery cell may affect a detection result, leading to an insufficient reliability of an accuracy and a stability of the detection result. In addition, the plurality of links requiring the manual operation may result in a low detection efficiency.

### SUMMARY

In view of this, the embodiments of the present disclosure provide a battery cell detection system and a method of detecting the same, so as to solve problems of low detection efficiency and poor detection accuracy in existing detection systems.

In a first aspect, a battery cell detection system is provided by the embodiments of the present disclosure, including: a loading device, a first detection device, a second detection device, a sorting device and an unloading device arranged in sequence in a conveying direction. The loading device is configured to transport a tray carrying a battery cell to a first inlet end of the first detection device; the first detection device is configured to detect the battery cell and generate a first detection sub-result; the second detection device is configured to detect the battery cell and generate a second detection sub-result; the sorting device is configured to sort the battery cell detected as abnormal to a first target region according to the first detection sub-result and the second detection sub-result; and the unloading device is configured to transport the battery cell detected as normal to a second target region.

According to the embodiments of the present disclosure, the battery cell detection system further includes: a posture adjustment device; the posture adjustment device is arranged at the first inlet end of the first detection device or a second inlet end of a second detection device; and the posture adjustment device is configured to adjust the tray to a preset posture, so that a target detection position of the battery cell is opposite to a detection end of the first detection device or the target detection position of the battery cell is opposite to a detection end of the second detection device.

According to the embodiments of the present disclosure, the battery cell detection system further includes: a first transfer device, a second transfer device and a first steering conveying line; the first steering conveying line is arranged between a first outlet end of the first detection device and the second inlet end of the second detection device; the first transfer device is arranged at the first outlet end, and the first transfer device is configured to transfer the tray at the first outlet end to a first end of the first steering conveying line; and the second transfer device is arranged at a second end of the first steering conveying line, and the second transfer device is configured to transfer the tray to the second inlet end.

According to the embodiments of the present disclosure, the battery cell detection system further includes: a third transfer device and a second steering conveying line; the sorting device is arranged in a conveying direction of a sorting conveying line, and the sorting conveying line has a third end close to the second detection device and a fourth end away from the second detection device; the second steering conveying line is arranged between the fourth end and the first inlet end, and a conveying direction of the second steering conveying line is parallel to a conveying direction of the first steering conveying line; and the third transfer device is arranged at the fourth end, the third transfer device is configured to transfer the tray at the fourth end to the second steering conveying line, and the second steering conveying line is configured to convey a tray carrying the normal battery cell, an empty tray and a tray carrying a to-be-detected battery cell.

According to the embodiments of the present disclosure, the battery cell detection system further includes: a loading conveying line; the loading conveying line is arranged on a side of the second steering conveying line, and the loading conveying line is configured to convey the to-be-detected battery cell; and the loading device is configured to place the to-be-detected battery cell on the loading conveying line on the empty tray on the second steering conveying line, and the second steering conveying line is configured to convey the tray carrying the to-be-detected battery cell to the first inlet end.

According to the embodiments of the present disclosure, the battery cell detection system further includes: an unloading conveying line; the unloading conveying line is arranged on a side of the second steering conveying line, and the unloading conveying line is configured to convey the battery cell detected as normal; and the unloading device is configured to separate the normal battery cell conveyed to the second steering conveying line by the sorting conveying line from the tray, and place the normal battery cell on the unloading conveying line.

In a second aspect, a method of detecting a battery cell detection system is provided by the embodiments of the present disclosure, including: transporting a to-be-detected battery cell to a first detection device based on a loading signal; detecting the battery cell by the first detection device based on a first detection signal, so as to obtain a first detection sub-result; transporting the to-be-detected battery cell to a second detection device; detecting the battery cell by the second detection device based on a second detection signal, so as to obtain a second detection sub-result; determining whether the battery cell is an abnormal battery cell or a normal battery cell based on the first detection sub-result and the second detection sub-result; and sorting the abnormal battery cell to a first target region, and transporting the normal battery cell to a second target region.

According to the embodiments of the present disclosure, before detecting the battery cell by the first detection device, the method further includes: adjusting a tray carrying the battery cell to a preset posture based on a posture adjustment signal, so that a target detection position of the battery cell is opposite to a detection end of the first detection device; or before detecting the battery cell by the second detection device, the method further includes: adjusting a tray carrying the battery cell to a preset posture based on a posture adjustment signal, so that a target detection position of the battery cell is opposite to a detection end of the second detection device.

According to the embodiments of the present disclosure, the step of transporting a to-be-detected battery cell to a first detection device includes: conveying the to-be-detected battery cell to a position corresponding to a loading device along with a loading conveying line; placing the battery cell on an empty tray on a second steering conveying line based on the loading signal; and conveying the tray carrying the battery cell to a first inlet end of the first detection device by the second steering conveying line.

According to the embodiments of the present disclosure, the step of transporting the to-be-detected battery cell to a second detection device includes: adjusting a tray from a preset posture to a target posture based on a first transfer signal; transferring the tray adjusted to the target posture to a first steering conveying line; and transferring the tray on the first steering conveying line to a second inlet end of the second detection device based on a second transfer signal.

According to the embodiments of the present disclosure, the step of sorting the abnormal battery cell to a first target region, and transporting the normal battery cell to a second target region includes: sorting the abnormal battery cell to the first target region by a sorting device based on a sorting signal, in response to the battery cell being determined as an abnormal battery cell; or transferring the normal battery cell to a second steering conveying line based on a third transfer signal, in response to the battery cell being determined as a normal battery cell; and transporting the normal battery cell to the second target region by an unloading device based on an unloading signal.

The battery cell detection system and the method of detecting the same provided in the embodiments of the present disclosure may at least realize the following technical effects: the loading device, the first detection device, the second detection device, the sorting device and the unloading device are arranged in sequence in the conveying direction of a conveying line, and an automatic operation of a whole detection task of loading, detection, sorting and unloading may be realized through a collaborative cooperation of various devices, the battery cell is comprehensively detected by the first detection device and the second detection device, which may effectively improve a detection efficiency and a detection accuracy of the battery cell detection system.

### BRIEF DESCRIPTION OF THE DRAWINGS

The above and other objectives, features, and advantages of the present disclosure will be more apparent through the following descriptions of the embodiments of the present disclosure with reference to the accompanying drawings, in which:
FIG. 1 schematically shows a schematic structural diagram of a battery cell detection system according to the embodiments of the present disclosure;
FIG. 2 schematically shows a schematic diagram of arranging a second detection device and a first detection device side by side according to the embodiments of the present disclosure; and
FIG. 3 schematically shows a flowchart of a detection method of a battery cell detection system according to the embodiments of the present disclosure.

### Reference signs:

10: loading device; 20: first detection device; 21: first conveyor line; 30: second detection device; 31: second conveyor line; 40: sorting device; 50: unloading device; 60: posture adjustment device; 70: first transfer device; 80: second transfer device; 90: third transfer device;
100: first steering conveyor line; 200: sorting conveyor line; 300: second steering conveyor line; 400: loading conveyor line; 500: unloading conveyor line; 600: battery cell.

### DETAILED DESCRIPTION OF EMBODIMENTS

In order to make objectives, technical solutions and advantages of the present disclosure clearer, the present disclosure will be further described in detail below with reference to specific embodiments and the accompanying drawings. Obviously, the described embodiments are some, but not all of embodiments of the present disclosure. Based on the embodiments of the present disclosure, all other embodiments obtained by those skilled in the art without any creative work fall within the scope of protection of the present disclosure.

Terms used here are only intended to describe specific embodiments and are not intended to limit the present disclosure. Terms such as "include", "include", used here indicate the presence of described features, steps, operations and/or components, but do not exclude the presence or addition of one or more other features, steps, operations or components.

In the descriptions of the present disclosure, it should be noted that, unless otherwise specified and limited, terms such as "installation", "coupling" and "connection" should be understood in a broad sense. For example, a "connection" may be a fixed connection, a detachable connection or an integrated connection; a "connection" may be a mechanical connection or an electrical connection; a "connection" may be a direct connection, an indirect connection through an intermediate medium, or an internal communication between two elements. For those skilled in the art, the specific meanings of the above-mentioned terms in the present disclosure may be understood according to specific situations.

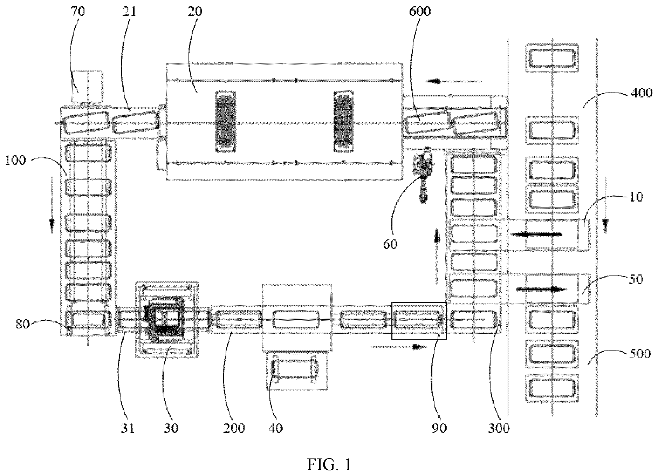

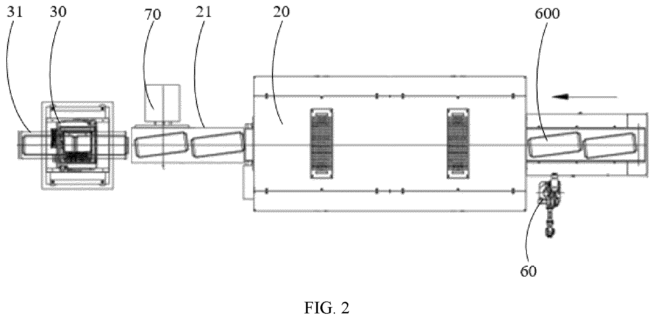

The battery cell detection system according to the embodiments of the present disclosure will be described with reference to FIG. 1 and FIG. 2.

As shown in FIG. 1, the battery cell detection system provided in the embodiments of the present disclosure includes: a loading device 10, a first detection device 20, a second detection device 30, a sorting device 40 and an unloading device 50 arranged in sequence in a conveying direction.

The loading device 10 is used to transport a tray carrying a battery cell 600 to a first inlet end of the first detection device 20; the first detection device 20 is used to detect the battery cell 600 and generate a first detection sub-result; the second detection device 30 is used to detect the battery cell 600 and generate a second detection sub-result; the sorting device 40 is used to sort an abnormal battery cell 600 to a first target region according to the first detection sub-result and the second detection sub-result; and the unloading device 50 is used to transport a battery cell 600 detected as normal to a second target region.

Specifically, the battery cell detection system includes a conveying line, and the loading device 10, the first detection device 20, the second detection device 30, the sorting device 40 and the unloading device 50 arranged in sequence in the conveying direction of the conveying line.

The loading device 10 is arranged at a loading position, and a to-be-detected battery cell 600 may be transferred to the loading position by a transport apparatus. A loading conveying line 400 may also be provided, and the to-be-detected battery cell 600 moves to the loading position along with the loading conveying line 400. A tray conveying line is provided on a side of the loading conveying line 400, and the tray conveying line is used to convey an empty tray.

For example, the to-be-detected battery cell 600 moves to the loading position along with the loading conveying line 400, and the loading device 10 may move linearly in a horizontal direction and a vertical direction. The loading device 10 includes a first driving portion and a first clamping portion. The first clamping portion includes two clamping claws which may be away from or close to each other. The first driving portion drives the two clamping claws to clamp the battery cell 600 on the loading conveying line 400 and place the battery cell 600 on an empty tray on the tray conveying line. The tray clamps the battery cell 600 to fix the battery cell 600 on the tray.

An external force may be applied to the tray by an operator or the loading device 10, so that the tray clamps the battery cell 600, and the tray carrying the battery cell 600 is further conveyed to the first inlet end of the first detection device 20 along with the tray conveying line.

The battery cell 600 is grabbed from the loading conveying line 400 and placed on the tray on the tray conveying line. The whole process is operated by the loading device 10 without a participation of the operator.

The first detection device 20 includes a first conveying line 21 and a first detection channel, and the first conveying line 21 includes the first inlet end and a first outlet end that are opposite to each other. The tray carrying the battery cell 600 is transported to the first inlet end and enters the first detection channel along with a movement of the first conveying line 21. A first detection mechanism is provided in the first detection channel. The first detection mechanism includes a first emitting unit and a first receiving unit located on two opposite sides of the battery cell 600. The first emitting unit and the first receiving unit synchronously perform a 360-degree rotation movement and perform spiral scanning on the battery cell 600. The first detection device 20 may be a CT detection apparatus, the first emitting unit is a CT ray machine, and the first receiving unit is a CT detector.

The first detection device 20 is a CT detection apparatus, and first scanning image of the battery cell 600 is acquired by the CT detection apparatus, and the first detection sub-result is obtained according to the first scanning image. The first detection device 20 may detect various defects of the battery cell 600, such as whether pole pieces in the battery cell 600 are aligned, whether the pole pieces are folded or missing, whether the pole pieces have welding defects, etc. The first detection device 20 mainly detects an alignment situation of the pole pieces of the battery cell 600.

After a detection of the battery cell 600 in the first detection channel is completed, the battery cell 600 moves to the first outlet end along with the movement of the first conveying line 21, and the battery cell 600 is further conveyed to the second detection device 30 for a second detection.

The second detection device 30 includes a second conveying line 31 and a second detection channel, and the second conveying line 31 includes a second inlet end and a second outlet end that are opposite to each other. A second detection mechanism is provided in the second detection channel. The second detection mechanism includes a second emitting unit and a second receiving unit located on two opposite sides of the battery cell 600. For example, in the vertical direction, the second emitting unit is located above the battery cell 600, and the second receiving unit is located below the battery cell 600, so as to scan the battery cell 600. The second detection device 30 may be a DR detection apparatus, the second emitting unit is a DR ray machine, and the second receiving unit is a DR detector.

As shown in FIG. 2, the second detection device 30 and the first detection device 20 are arranged side by side. In such case, the second inlet end of the second detection device 30 is opposite to the first outlet end of the first detection device 20.

As shown in FIG. 1, the second detection device 30 and the first detection device 20 are arranged in parallel at an interval, and a first steering conveying line 100 is provided between the second detection device 30 and the first detection device 20. The first steering conveying line 100 has a first end and a second end that are opposite to each other. The first end of the first steering conveying line 100 is opposite to the first outlet end of the first detection device 20, and the second end of the first steering conveying line 100 is opposite to the second inlet end of the second detection device 30. The tray at the first outlet end moves to the second inlet end through the first steering conveying line 100.

The second detection device 30 is a DR detection apparatus. A second scanning image of the battery cell 600 is acquired by the DR detection apparatus, and the second detection sub-result is obtained according to the second scanning image. The second detection device 30 may detect impurities and internal defects in the battery cell 600, such as whether impurities and foreign substances exist in the battery cell 600, whether pole pieces of the battery cell 600 are wrinkled, folded or damaged, etc. The second detection device 30 mainly detects an internal defect situation of the battery cell 600.

It may be understood that a position of the first detection device 20 and a position of the second detection device 30 may be interchanged. That is, the battery cell 600 may be detected by the CT detection apparatus first, and then the battery cell 600 is detected by the DR detection apparatus. Alternatively, the battery cell 600 may be detected by the DR detection apparatus first, and then the battery cell 600 may be detected by the CT detection apparatus.

The first detection device 20 may generate the first scanning image after detecting the battery cell 600, and the first detection sub-result is obtained according to the first scanning image. The second detection device 30 may generate the second scanning image after detecting the battery cell 600, the second detection sub-result is obtained according to the second scanning image, and whether the battery cell 600 is an abnormal battery cell or a normal battery cell is determined according to the first detection sub-result and the second detection sub-result.

The battery cell 600 detected by the first detection device 20 and the second detection device 30 is conveyed to the sorting device 40 for sorting processing according to a determination result.

If the battery cell 600 is determined as an abnormal battery cell, the abnormal battery cell is sorted by the sorting device 40 to the first target region which may be an unqualified product collection warehouse, the abnormal battery cell on the conveying line is grabbed by the sorting device 40 and put into the unqualified product collection warehouse.

Further, the abnormal battery cell is put into the unqualified product collection warehouse together with the tray, and an empty tray may be supplemented to the conveying line by the sorting device 40.

If the battery cell 600 is determined as a normal battery cell, the normal battery cell is further conveyed to an unloading position. The unloading device 50 is arranged at the unloading position. A structure of the unloading device 50 is similar to a structure of the loading device 10. The unloading device 50 may move linearly in the horizontal direction and the vertical direction. The unloading device 50 includes a second driving portion and a second clamping portion, and the second clamping portion includes two clamping claws that may be away from or close to each other.

It may be understood that an unlocking action may be applied on the tray by the unloading device, the normal battery cell is released by the tray, and the second driving portion drives the two clamping jaws to clamp the separated normal battery cell and places the normal battery cell in the second target region. The second target region may be an unloading conveying line 500, and the normal battery cell is conveyed to a next position along with the unloading conveying line 500 for a next process operation.

A manipulator of the loading device 10 and a manipulator of the unloading device 50 may be truss manipulators or multi-axis manipulators.

A detection process of the battery cell detection system will be described below.

The to-be-detected battery cell 600 moves to the loading position, and the loading device 10 places the to-be-detected battery cell 600 on the tray. After the tray clamps the battery cell 600, the tray carrying the battery cell 600 is conveyed to the first detection device 20. The first detection device 20 detects the battery cell 600 and generates the first scanning image, and the first detection sub-result is obtained according to the first scanning image. The detected battery cell 600 detected by the first detection device 20 is conveyed to the second detection device 30, and the second detection device 30 detects the battery cell 600 and generates the second scanning image, and the second detection sub-result is obtained according to the second scanning image. After that, the battery cell 600 is conveyed to the sorting device 40, and the sorting device 40 performs sorting processing on the battery cell 600 according to the first detection sub-result and the second detection sub-result. If the battery cell 600 is determined as an abnormal battery cell, the sorting device 40 transports the abnormal battery cell to the first target region. If the battery cell 600 is determined as a normal battery cell, the normal battery cell is conveyed to the unloading position. The unloading device 50 applies an unlocking action on the tray, and the tray releases the battery cell 600. The unloading device 50 further places the normal battery cell on the unloading conveying line 500, and the normal battery cell is conveyed to a next position along with the unloading conveying line 500 for a subsequent process operation. The empty tray is further conveyed to the loading position to carry a next to-be-detected battery cell 600, thereby realizing recycling of the tray.

The to-be-detected battery cell 600 and the tray are fixed by the loading device 10, and the battery cell 600 is transported to the first detection device 20. The alignment situation of the pole pieces of the battery cell 600 and the internal situation of the battery cell 600 are comprehensively detected by the first detection device 20 and the second detection device 30. The sorting device 40 sorts the abnormal battery cell to the first target region according to the first detection sub-result and the second detection sub-result. The normal battery cell is separated from the tray by the unloading device 50, and the normal battery cell is transported to the second target region. In a whole detection process, a participation of the operator may be greatly reduced, and an automatic operation of a whole detection task of loading, detection, sorting and unloading may be realized through a collaborative cooperation of the various devices, which may effectively improve a detection efficiency and a detection accuracy.

In the embodiments of the present disclosure, the loading device 10, the first detection device 20, the second detection device 30, the sorting device 40 and the unloading device 50 are arranged in sequence in the conveying direction of the conveying line. The automatic operation of the whole detection task of loading, detection, sorting and unloading may be realized through the collaborative cooperation of the various devices. The battery cell 600 is comprehensively detected by the first detection device 20 and the second detection device 30, which may effectively improve the detection efficiency and the detection efficiency of the battery cell detection system.

As shown in FIG. 1, in an alternative embodiment, the battery cell detection system further includes a posture adjustment device 60 arranged at the first inlet end of the first detection device 20 or the second inlet end of the second detection device 30. The posture adjustment device 60 is used to adjust the tray to a preset posture, so that a target detection position of the battery cell 600 is opposite to a detection end of the first detection device 20 or the target detection position of the battery cell 600 is opposite to a detection end of the second detection device 30.

Specifically, one of the first detection device 20 and the second detection device 30 is used to detect the alignment situation of the pole pieces of the battery cell 600. For example, the first detection device 20 is a CT detection apparatus, and the first detection device 20 detects the alignment situation of the pole pieces of the battery cell 600.

The posture adjustment device 60 is arranged at the first inlet end of the first detection device 20. A manipulator of the posture adjustment device 60 may move and rotate in three mutually perpendicular directions, and the tray may be adjusted to a preset posture through a linear movement action and a rotation action of the manipulator, that is, a placement angle of the tray may be adjusted. In the preset posture, the target detection position of the battery cell 600 is opposite to the detection end of the first detection device 20, and the target detection position of the battery cell 600 is a diagonal position of the battery cell 600.

Taking the battery cell 600 having a rectangular shape as an example, the battery cell 600 has a length direction and a width direction. Along a circumference of the battery cell 600, four corner positions of the battery cell 600 are defined as a first endpoint, a second endpoint, a third endpoint and a fourth endpoint, respectively. The first endpoint and the third endpoint are located on a first diagonal line, and the second endpoint and the fourth endpoint are located on a second diagonal line.

The first endpoint and the third endpoint on the first diagonal line are target detection positions, and the first endpoint and the third endpoint are located on a center line of the first detection device 20 through an adjustment action of the posture adjustment device 60. It may be understood that the second endpoint and the fourth endpoint may also be located on the center line of the first detection device 20. The placement angle of the tray is an included angle formed between a center surface of the tray and a center line of the first detection device 20, and in the preset posture, the placement angle of the tray is defined as a first placement angle.

The placement angle of the tray is adjusted by the posture adjustment device 60, so that the target detection position of the battery cell 600 may be opposite to the detection end, so as to accurately detect the alignment situation of the pole pieces in the battery cell 600. It may be understood that, for battery cells 600 with different sizes and specifications, the first placement angles of the trays may be different, and the first placement angles of the trays may be 20 degrees, 30 degrees, 35 degrees, 40 degrees, 45 degrees, etc., as long as the endpoint on the diagonal line of the battery cell 600 being located on the center line of the first detection device 20.

Through an independent control of the posture adjustment device 60, the first placement angle may be adjusted according to a type of the battery cell 600, which may meet detection requirements of the battery cells with different sizes and specifications and have a strong adaptability.

If both the first detection device 20 and the second detection device 30 are CT detection apparatuses, a posture adjustment device 60 is arranged at the first inlet end of the first detection device 20 and another posture adjustment device 60 is arranged at the second inlet end of the second detection device 30. After a detection of the first endpoint and the third endpoint of the battery cell 600 is completed at the first detection device 20, the battery cell 600 is conveyed to the second inlet end of the second detection device 30. The posture adjustment device 60 at the second inlet end of the second detection device 30 adjusts the placement angle of the tray by referring to the above-mentioned adjustment method, so that the second endpoint and the fourth endpoint on the second diagonal line of the battery cell 600 are located on a center line of the second detection device 30. Therefore, a detection of the second endpoint and the fourth endpoint of the battery cell 600 may be completed by the second detection device 30.

The placement angle of the tray is adjusted by the posture adjustment device 60. Compared with a manual adjustment of the placement angle of the tray, the posture adjustment device 60 may adjust the placement angle more quickly and accurately, thereby avoiding an error and uncontrollability caused by manual operation, and further contributing to improving an accuracy and reliability of the detection result.

In the embodiments of the present disclosure, the posture adjustment device 60 is arranged at the first inlet end of the first detection device 20 or the second inlet end of the second detection device 30, and the placement angle of the tray is adjusted by the posture adjustment device 60, so that the target detection position of the battery cell 600 is opposite to the detection end, which is beneficial to ensuring an accuracy of a placement position of the battery cell 600 and further improving the accuracy and reliability of the detection result.

As shown in FIG. 1, in an alternative embodiment, the battery cell detection system further includes a first transfer device 70, a second transfer device 80 and the first steering conveying line 100.

The first steering conveying line 100 is arranged between the first outlet end of the first detection device 20 and the second inlet end of the second detection device 30. The first transfer device 70 is arranged at the first outlet end, used to transfer the tray at the first outlet end to a first end of the first steering conveying line 100. The second transfer device 80 is arranged at a second end of the first steering conveying line 100, used to transfer the tray to the second inlet end.

Specifically, the first detection device 20 and the second detection device 30 are arranged in parallel at an interval. The first detection device 20 includes the first conveying line 21, and the second detection device 30 includes the second conveying line 31. A conveying direction of the first conveying line 21 and a conveying direction of the second conveying line 31 are parallel and opposite to each other.

The first steering conveying line 100 is located between the first outlet end of the first detection device 20 and the second inlet end of the second detection device 30. A conveying direction of the first steering conveying line 100 is perpendicular to the conveying direction of the first conveying line 21, and the conveying direction of the first steering conveying line 100 is perpendicular to the conveying direction of the second conveying line 31.

The first steering conveying line 100 has a first end and a second end that are opposite to each other, and the first transfer device 70 is located at the first outlet end of the first detection device 20. The first transfer device 70 may be a push rod transfer apparatus, the push rod transfer apparatus includes a first push rod and a second push rod that are parallel to each other, and a pushing stroke of the first push rod is different from a pushing stroke of the second push rod.

The battery cell 600 that has been detected in the first detection channel moves to the first outlet end along with the movement of the first conveying line 21. At this time, the tray is still in the preset posture, and the placement angle of the tray at this time is the first placement angle, which may be 30 degrees.

The first transfer device 70 adjusts the tray from the preset posture to a target posture. The first push rod and the second push rod of the first transfer device 70 move toward a direction of the tray, and the two push rods exert different degrees of thrust on the tray to adjust the tray from the first placement angle to a second placement angle, and push the tray from the first outlet end to the first end of the first steering conveying line 100. At the second placement angle, the center surface of the tray is parallel to a center line of the first conveying line 21, and the second placement angle is 0 degree.

The tray carrying the battery cell 600 moves to the second end along with the first steering conveying line 100, and the second transfer device 80 is arranged at the second end of the first steering conveying line 100. The second transfer device 80 may be a lifting transfer apparatus, and the lifting transfer apparatus includes a lifting mechanism and a rotating mechanism. The tray moved to the second end is lifted to a target height by the lifting mechanism. With a rotation of the rotating mechanism, the tray further moves to the second inlet end of the second detection device 30.

It may be understood that a rotating direction of the rotating mechanism is perpendicular to a rotating direction of the first steering conveying line 100, thereby realizing an adjustment of a movement direction of the tray.

The adjustment of the tray placement angle is realized by using the first transfer device 70, so that the tray is adjusted from the first placement angle to the second placement angle. In addition, the first transfer device 70 transfers the tray to the first steering conveying line 100. The second transfer device 80 transfers the tray moved to the second end to the second inlet end of the second detection device 30.

A U-shaped conveying direction is formed among the first conveying line 21, the first steering conveying line 100 and the second conveying line 31, which is beneficial to a compactness of an overall structure of the battery cell detection system and reducing an occupied space of the battery cell detection system.

Without the participation of the operator, the adjustment of the placement angle of the tray is realized by using the first transfer device 70, and the adjustment of the conveying direction of the tray is realized by using the first transfer device 70 and the second transfer device 80, which is beneficial to an intelligent operation of the battery cell detection system.

As shown in FIG. 1, in an alternative embodiment, the battery cell detection system further includes a third transfer device 90 and a second steering conveying line 300.

The sorting device 40 is arranged in a conveying direction of a sorting conveying line 200, and the sorting conveying line 200 has a third end close to the second detection device 30 and a fourth end away from the second detection device 30. The second steering conveying line 300 is arranged between the fourth end and the first inlet end, and a conveying direction of the second steering conveying line 300 is parallel to the conveying direction of the first steering conveying line 100. The third transfer device 90 is arranged at the fourth end, used to transfer the tray at the fourth end to the second steering conveying line 300. The second steering conveying line 300 is used to convey the tray carrying a normal battery cell, the empty tray and the tray carrying a to-be-detected battery cell.

Specifically, the sorting device 40 is arranged in the conveying direction of the sorting conveying line 200, the sorting conveying line 200 has a third end and a fourth end that are opposite to each other, and the third end is opposite to the second outlet end of the second detection device 30.

The second steering conveying line 300 and the first steering conveying line 100 are arranged in parallel at an interval. The second steering conveying line 300 has a fifth end and a sixth end that are opposite to each other. The fifth end is opposite to the fourth end of the sorting conveying line 200, and the sixth end is opposite to the first inlet end of the first detection device 20.

Therefore, the first conveying line 21, the first steering conveying line 100, the second conveying line 31, the sorting conveying line 200 and the second steering conveying line 300 form a loop-shaped detection conveying line. The first conveying line 21, the first steering conveying line 100, the second conveying line 31, the sorting conveying line 200 and the second steering conveying line 300 may include a double-speed chain conveying structure, an O-shaped belt conveying structure, etc.

The third transfer device 90 is arranged at the fourth end of the sorting conveying line 200. The third transfer device 90 may be a lifting transfer apparatus including a lifting mechanism and a rotating mechanism. The tray is lifted to a target height by the lifting mechanism, and the tray is transferred to the second steering conveying line 300 by the rotating mechanism.

The tray carrying the normal battery cell moves to the unloading position corresponding to the unloading device 50 along with the second steering conveying line 300, and the unloading device 50 applies an unlocking action to the tray, so that the tray releases the normal battery cell. After that, the unloading device 50 transports the normal battery cell to the unloading conveying line 500 for a subsequent operation.

The tray separated from the normal battery cell moves to the loading position corresponding to the loading device 10 along with the second steering conveying line 300. The loading device 10 grabs the to-be-detected battery cell 600 on the loading conveying line 400 and places the battery cell 600 on the tray. Through a locking action, the tray clamps the battery cell 600, and the tray carrying the battery cell 600 moves to the first inlet end of the first detection device 20 along with the second steering conveying line 300.

The first conveying line 21, the first steering conveying line 100, the second conveying line 31, the sorting conveying line 200 and the second steering conveying line 300 form a loop-shaped detection conveying line, and the loading device 10, the posture adjustment device 60, the first detection device 20, the first transfer device 70, the second transfer device 80, the sorting device 40, the third transfer device 90 and the unloading device 50 are arranged in sequence in a conveying direction of the detection conveying line, which may not only improve the structural compactness of the battery cell detection system, but also help to save the occupied space of the battery cell detection system.

The tray moves along with the conveying direction of the detection conveying line, thereby realizing recycling of the tray. By controlling a conveying speed of each conveying line, a sequential detection of a plurality of battery cells 600 may be realized, which is beneficial to improving the detection efficiency.

As shown in FIG. 1, in an alternative embodiment, the battery cell detection system further includes the loading conveying line 400. The loading conveying line 400 is arranged on a side of the second steering conveying line 300, and the loading conveying line 400 is used to convey the to-be-detected battery cell 600. The loading device 10 is used to place the to-be-detected battery cell 600 on the loading conveying line 400 on the empty tray on the second steering conveying line 300, and the second steering conveying line 300 is used to convey the tray carrying the battery cell 600 to the first inlet end.

Specifically, the loading conveying line 400 is arranged close to the second steering conveying line 300, and the to-be-detected battery cell 600 moves to the loading position along with the loading conveying line 400.

The loading device 10 grabs the battery cell 600 on the loading conveying line 400 and transports the battery cell 600 to the empty tray on the second steering conveying line 300, and the tray carrying the battery cell 600 further moves to the first inlet end along with the second steering conveying line 300.

By providing the loading conveying line 400, the to-be-detected battery cell 600 moves to the loading position along with the loading conveying line 400, which is beneficial to further improving the intelligent operation of the battery cell detection system.

As shown in FIG. 1, in an alternative embodiment, the battery cell detection system further includes the unloading conveying line 500. The unloading conveying line 500 is arranged on a side of the second steering conveying line 300, and the unloading conveying line 500 is used to convey the battery cell detected as normal. The unloading device 50 is used to separate the normal battery cell conveyed by the sorting conveying line 200 to the second steering conveying line 300 from the tray, and place the normal battery cell on the unloading conveying line 500.

Specifically, the unloading conveying line 500 is arranged close to the second steering conveying line 300. The tray carrying the normal battery cell moves to the unloading position along with the second steering conveying line 300. At the unloading position, the tray releases the normal battery cell, and the unloading device 50 grabs the normal battery cell and transports the normal battery cell to the unloading conveying line 500. The normal battery cell further moves to a next position along with a movement of the unloading conveying line 500 for a subsequent operation.

By providing the unloading conveying line 500, the battery cell detected as normal moves to the next position along with the unloading conveying line 500, which is beneficial to further improving the intelligent operation of the battery cell detection system.

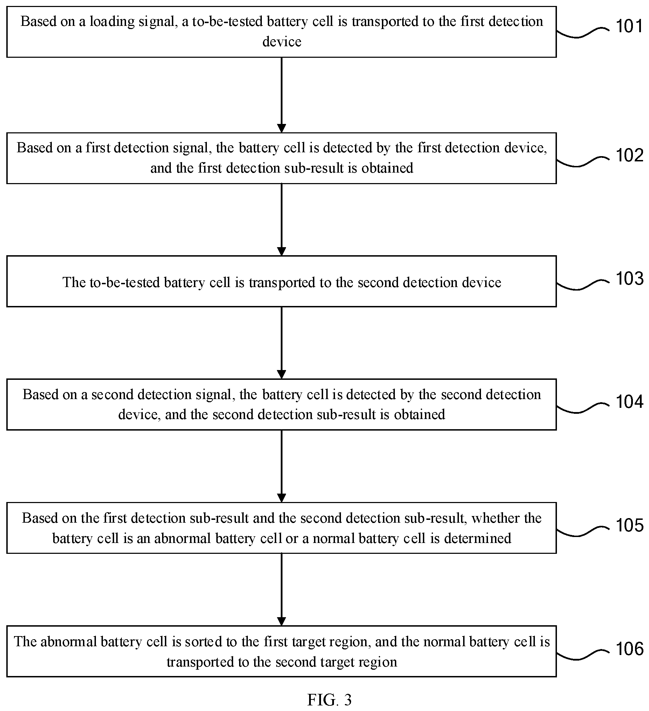

As shown in FIG. 3, the embodiments of the present disclosure further provide a method of detecting a battery cell detection system. The method includes:
Step 101, the to-be-detected battery cell 600 is transported to the first detection device 20 based on a loading signal.
Step 102, the battery cell 600 is detected by the first detection device 20 based on a first detection signal, and the first detection sub-result is obtained.
Step 103, the to-be-detected battery cell 600 is transported to the second detection device 30.
Step 104, the battery cell 600 is detected by the second detection device 30 based on a second detection signal, and the second detection sub-result is obtained.
Step 105, whether the battery cell 600 is an abnormal battery cell or a normal battery cell is determined based on the first detection sub-result and the second detection sub-result.
Step 106, the abnormal battery cell is sorted to the first target region, and the normal battery cell is transported to the second target region.

Specifically, a structure of the battery cell detection system has been described above, which will not be repeated here. The loading device 10, the first detection device 20, the first transfer device 70, the second transfer device 80, the second detection device 30, the sorting device 40 and the unloading device 50 are arranged in sequence in the conveying direction of the detection conveying line. Each device is in communicative connection with a controller.

The loading device 10 receives the loading signal and transports the to-be-detected battery cell 600 to the first inlet end of the first detection device 20. After the tray carrying the battery cell 600 is adjusted to the first placement angle, the tray moves into the first detection channel. The first detection mechanism receives the first detection signal and the target detection position of the battery cell 600 is detected by the first detection mechanism. The first scanning image is generated by spirally scanning endpoints on the diagonal line of the battery cell 600, and the first detection sub-result is obtained from the first scanning image. The detected battery cell 600 moves to the first outlet end along with the first conveying line 21.

The first transfer device 70 receives a first transfer signal and adjusts the tray carrying the battery cell 600 to the second placement angle, and transfers the battery cell 600 at the first outlet end to the first steering conveying line 100, and the battery cell 600 moves to the second end along with the first steering conveying line 100. The second transfer device 80 receives a second transfer signal and transfers the battery cell 600 at the second end to the second inlet end of the second detection device 30.

The tray carrying the battery cell 600 moves into the second detection channel. The second detection mechanism receives a second detection signal and detects the target detection position of the battery cell 600. The second scanning image is generated by spirally scanning the battery cell 600, and the second detection sub-result is obtained from the second scanning image. The detected battery cell 600 moves from the second conveying line 31 to the sorting conveying line 200.

Whether the battery cell 600 is detected as a normal battery cell or an abnormal battery cell is determined according to the first detection sub-result and the second detection sub-result. The first detection sub-result is qualified or unqualified, the second detection sub-result is qualified or unqualified. When both the first detection sub-result and the second detection sub-result are qualified, the battery cell 600 is determined as a normal battery cell. When at least one of the first detection sub-result and the second detection sub-result is unqualified, the battery cell 600 is determined as an abnormal battery cell.

When the battery cell 600 is determined as an abnormal battery cell, the sorting device 40 receives a sorting signal, and the sorting device 40 sorts the abnormal battery cell to the first target region which may be an unqualified product collection warehouse.

When the battery cell 600 is determined as a normal battery cell, the sorting device 40 receives a releasing signal, and the tray carrying a normal battery cell moves to the unloading position.

The unloading device 50 receives an unloading signal and transports the normal battery cell to the second target region for a next process operation.

In the whole detection process, the participation of the operator may be greatly reduced, and the automatic operation of the whole detection task of loading, detection, sorting and unloading may be realized through the collaborative cooperation of all devices. The first detection device 20 detects the alignment situation of the pole pieces of the battery cell 600, and the second detection device 30 detects the situation of the internal defects of the battery cell 600, and the battery cell 600 is comprehensively detected by the first detection device 20 and the second detection device 30. The above-mentioned detection method may effectively improve the detection efficiency and the detection accuracy.

In an alternative embodiment, before detecting the battery cell 600 by the first detection device 20, the method further includes: the tray carrying the battery cell 600 is adjusted to the preset posture, based on a posture adjustment signal, so that the target detection position of the battery cell 600 is opposite to the detection end of the first detection device 20; or
before detecting the battery cell 600 by the second detection device 30, the method further includes: the tray carrying the battery cell 600 is adjusted to the preset posture based on a posture adjustment signal, so that the target detection position of the battery cell 600 is opposite to the detection end of the second detection device 30.

Specifically, the first detection device 20 is a CT detection apparatus, and the posture adjustment device 60 is arranged at the first inlet end of the first detection device 20; the second detection device 30 is a CT detection apparatus, and the posture adjustment device 60 is arranged at the second inlet end of the second detection device 30.

Taking the posture adjustment device 60 being arranged at the first inlet end as an example, the tray moves to the first inlet end, the posture adjustment device 60 receives the posture adjustment signal, and the posture adjustment device 60 adjusts the tray carrying the battery cell 600 to the first placement angle, so that the target detection position of the battery cell 600 may be opposite to the detection end of the first detection mechanism.

The manipulator of the posture adjustment device 60 may move and rotate in three mutually perpendicular directions, and the tray is adjusted to the preset posture through a linear movement action and a rotation action of the manipulator, so that the first endpoint and the third endpoint on the diagonal line of the battery cell 600 are located on the center line of the first detection device 20, or the second endpoint and the fourth endpoint on the diagonal line of the battery cell 600 are located on the center line of the first detection device 20. The first detection mechanism performs spiral scanning around the first endpoint and the third endpoint to accurately detect the alignment situation of the pole pieces of the battery cell 600.

The placement angle of the tray is adjusted by the posture adjustment device 60. Compared with a manual adjustment of the placement angle of the tray, the posture adjustment device 60 may adjust the placement angle more quickly and accurately, thereby avoiding an error and uncontrollability caused by manual operation, and further contributing to improving the accuracy and reliability of the detection result.

In an alternative embodiment, the step of transporting the to-be-detected battery cell 600 to the first detection device 20 includes:
the to-be-detected battery cell 600 is conveyed to a position corresponding to the loading device 10 along with the loading conveying line 400;
the battery cell 600 is placed on the empty tray on the second steering conveying line 300 based on the loading signal; and
the tray carrying the battery cell 600 is conveyed to the first inlet end of the first detection device 20 by the second steering conveying line 300.

Specifically, the first conveying line 21, the first steering conveying line 100, the second conveying line 31, the sorting conveying line 200 and the second steering conveying line 300 form a loop-shaped detection conveying line. The loading conveying line 400 and the second steering conveying line 300 are parallel to each other.

The to-be-detected battery cell 600 moves to the loading position along with the loading conveying line 400. The loading device 10 receives the loading signal. The loading device 10 grabs the battery cell 600 on the loading conveying line 400, and places the battery cell 600 on the empty tray on the second steering conveying line 300. The tray clamps the battery cell 600, and the tray carrying the battery cell 600 moves to the first inlet end of the first detection device 20 along with the second steering conveying line 300.

Through a collaborative cooperation of the loading conveying line 400, the second steering conveying line 300 and the loading device 10, the tray carrying the battery cell 600 is transported to the first inlet end, so as to realize the intelligent operation of the battery cell detection system.

In an alternative embodiment, the step of transporting the to-be-detected battery cell 600 to the second detection device 30 includes:
the tray is adjusted from the preset posture to the target posture based on the first transfer signal;
the tray adjusted to the target posture is transferred to the first steering conveying line 100; and
the tray on the first steering conveyor 100 is transferred to the second inlet end of the second detection device 30 based on the second transfer signal.

Specifically, after a detection of the battery cell 600 in the first detection channel is completed, the battery cell 600 moves to the first outlet end of the first detection device 20. At this time, the tray is still in the preset posture, and the tray is at the first placement angle which may be 30 degrees.

Through pushing actions of the first push rod and the second push rod of the first transfer device 70, the tray is adjusted from the preset posture to the target posture. In the target posture, the tray is at the second placement angle which is 0 degree.

The tray moves to the first outlet end of the first detection device 20, the first transfer device 70 receives the first transfer signal, and the tray is adjusted from the first placement angle to the second placement angle through a pushing action of the first transfer device 70, and the tray is pushed onto the first steering conveying line 100.

The tray moves to the second end along with the first steering conveying line 100, the second transfer device 80 receives the second transfer signal. The movement direction of the tray is changed through the lifting action and the rotating action of the second transfer device 80, and the tray is transferred to the second inlet end of the second detection device 30.

Without the participation of the operator, the adjustment of the placement angle of the tray may be realized by the first transfer device 70 and the adjustment of the movement direction of the tray may be realized by the second transfer device 80, which is beneficial to the intelligent operation of the battery cell detection system.

In an alternative embodiment, the step of sorting the abnormal battery cell to the first target region, and transporting the normal battery cell to the second target region includes:
the abnormal battery cell is sorted to the first target region by the sorting device 40 based on the sorting signal when the battery cell 600 is determined as an abnormal battery cell; or the normal battery cell is transferred to the second steering line body 300 based on a third transfer signal when the battery cell 600 is determined as a normal battery cell; and
the normal battery cell is transferred to the second target region by the unloading device 50 based on the unloading signal.

Specifically, the battery cell 600 detected by the first detection device 20 and the second detection device 30 moves to the sorting device 40. Whether the battery cell 600 is a normal battery cell or an abnormal battery cell is determined according to the first detection sub-result and the second detection sub-result.

When the battery cell 600 is determined as an abnormal battery cell, the sorting device 40 receives the sorting signal, and the sorting device 40 grabs the abnormal battery cell and places the abnormal battery cell in the unqualified product collection warehouse.

When the battery cell 600 is determined as a normal battery cell, the sorting device 40 receives the releasing signal, and the tray carrying the normal battery cell moves to the third transfer device 90 along with the sorting conveying line 200.

The third transfer device 90 receives the third transfer signal and transfers the tray carrying the normal battery cell to the second steering conveying line 300, and the normal battery cell further moves to the unloading position along with the second steering conveying line 300.

The unloading device 50 receives the unloading signal, the normal battery cell is separated from the tray, the unloading device 50 grabs the normal battery cell and places the normal battery cell on the unloading conveying line 500. The normal battery cell moves to the next position along with the unloading conveying line 500 for a subsequent operation.

The above are only specific embodiments of the present disclosure, but the scope of protection of the present disclosure is not limited thereto. Any changes or substitutions made within the spirit and principle of the present disclosure should be covered by the scope of protection of the present disclosure. Therefore, the scope of protection of the present disclosure should be defined by the scope of protection of the claims.

## Claims

1. A battery cell detection system, comprising:
a loading device (10), a first detection device (20), a second detection device (30), a sorting device (40) and an unloading device (50) arranged in sequence in a conveying direction,
wherein the loading device (10) is configured to transport a tray carrying a battery cell (600) to a first inlet end of the first detection device (20);
wherein the first detection device (20) is configured to detect the battery cell (600) and generate a first detection sub-result;
wherein the second detection device (30) is configured to detect the battery cell (600) and generate a second detection sub-result;
wherein the sorting device (40) is configured to sort the battery cell (600) detected as abnormal to a first target region according to the first detection sub-result and the second detection sub-result; and
wherein the unloading device (50) is configured to transport the battery cell (600) detected as normal to a second target region.

2. The battery cell detection system according to claim 1, further comprising: a posture adjustment device (60);
wherein the posture adjustment device (60) is arranged at the first inlet end of the first detection device (20) or a second inlet end of a second detection device (30); and
wherein the posture adjustment device (60) is configured to adjust the tray to a preset posture, so that a target detection position of the battery cell (600) is opposite to a detection end of the first detection device (20) or the target detection position of the battery cell (600) is opposite to a detection end of the second detection device (30).

3. The battery cell detection system according to claim 2, further comprising: a first transfer device (70), a second transfer device (80) and a first steering conveying line (100);
wherein the first steering conveying line (100) is arranged between a first outlet end of the first detection device (20) and the second inlet end of the second detection device (30);
wherein the first transfer device (70) is arranged at the first outlet end, and the first transfer device (70) is configured to transfer the tray at the first outlet end to a first end of the first steering conveying line (100); and
wherein the second transfer device (80) is arranged at a second end of the first steering conveying line (100), and the second transfer device (80) is configured to transfer the tray to the second inlet end.

4. The battery cell detection system according to claim 3, further comprising: a third transfer device (90) and a second steering conveying line (300);
wherein the sorting device (40) is arranged in a conveying direction of a sorting conveying line (200), and the sorting conveying line (200) has a third end close to the second detection device (30) and a fourth end away from the second detection device (30);
wherein the second steering conveying line (300) is arranged between the fourth end and the first inlet end, and a conveying direction of the second steering conveying line (300) is parallel to a conveying direction of the first steering conveying line (100); and
wherein the third transfer device (90) is arranged at the fourth end, the third transfer device (90) is configured to transfer the tray at the fourth end to the second steering conveying line (300), and the second steering conveying line (300) is configured to convey a tray carrying the normal battery cell (600), an empty tray and a tray carrying a to-be-detected battery cell (600).

5. The battery cell detection system according to claim 4, further comprising: a loading conveying line (400);
wherein the loading conveying line (400) is arranged on a side of the second steering conveying line (300), and the loading conveying line (400) is configured to convey the to-be-detected battery cell (600); and
wherein the loading device (10) is configured to place the to-be-detected battery cell (600) on the loading conveying line (400) on the empty tray on the second steering conveying line (300), and the second steering conveying line (300) is configured to convey the tray carrying the to-be-detected battery cell (600) to the first inlet end.

6. The battery cell detection system according to claim 4, further comprising: an unloading conveying line (500);
wherein the unloading conveying line (500) is arranged on a side of the second steering conveying line (300), and the unloading conveying line (500) is configured to convey the battery cell (600) detected as normal; and
wherein the unloading device (50) is configured to separate the normal battery cell (600) conveyed to the second steering conveying line (300) by the sorting conveying line (200) from the tray, and place the normal battery cell (600) on the unloading conveying line (500).

7. A method of detecting a battery cell detection system, comprising:
transporting a to-be-detected battery cell (600) to a first detection device (20) based on a loading signal;
detecting the battery cell (600) by the first detection device (20) based on a first detection signal, so as to obtain a first detection sub-result;
transporting the to-be-detected battery cell (600) to a second detection device (30);
detecting the battery cell (600) by the second detection device (30) based on a second detection signal, so as to obtain a second detection sub-result;
determining whether the battery cell (600) is an abnormal battery cell or a normal battery cell based on the first detection sub-result and the second detection sub-result; and
sorting the abnormal battery cell (600) to a first target region, and transporting the normal battery cell (600) to a second target region.

8. The method according to claim 7, wherein before detecting the battery cell (600) by the first detection device (20), the method further comprises:
adjusting a tray carrying the battery cell (600) to a preset posture based on a posture adjustment signal, so that a target detection position of the battery cell (600) is opposite to a detection end of the first detection device (20); or
wherein before detecting the battery cell (600) by the second detection device (30), the method further comprises:
adjusting a tray carrying the battery cell (600) to a preset posture based on a posture adjustment signal, so that a target detection position of the battery cell (600) is opposite to a detection end of the second detection device (30).

9. The method according to claim 7, wherein the step of transporting a to-be-detected battery cell (600) to a first detection device (20) comprises:
conveying the to-be-detected battery cell (600) to a position corresponding to a loading device (10) along with a loading conveying line (400);
placing the battery cell (600) on an empty tray on a second steering conveying line (300) based on the loading signal; and
conveying the tray carrying the battery cell (600) to a first inlet end of the first detection device (20) by the second steering conveying line (300).

10. The method according to claim 7, wherein the step of transporting the to-be-detected battery cell (600) to a second detection device (30) comprises:
adjusting a tray from a preset posture to a target posture based on a first transfer signal;
transferring the tray adjusted to the target posture to a first steering conveying line (100); and
transferring the tray on the first steering conveying line (100) to a second inlet end of the second detection device (30) based on a second transfer signal.

11. The method according to claim 10, wherein the step of sorting the abnormal battery cell (600) to a first target region, and transporting the normal battery cell (600) to a second target region comprises:
sorting the abnormal battery cell (600) to the first target region by a sorting device (40) based on a sorting signal, in response to the battery cell (600) being determined as an abnormal battery cell; or
transferring the normal battery cell (600) to a second steering conveying line (300) based on a third transfer signal, in response to the battery cell (600) being determined as a normal battery cell; and
transporting the normal battery cell (600) to the second target region by an unloading device (50) based on an unloading signal.
